# FASCICULE DE BREVET EUROPEEN

(11) **EP 1 576 660 B1**
(45) Date de publication et mention de la délivrance du brevet: **27.04.2016**
(21) Numéro de dépôt: 03814487.9
(22) Date de dépôt: 23.12.2003
(51) Int. Cl.: H01L 21/208, H01L 31/032, H01L 31/18

(54) **PROCEDE DE FABRICATION D'UN COMPOSE I-III-VI EN COUCHES MINCES, FAVORISANT L'INCORPORATION D'ELEMENTS III DANS LA COUCHE**
VERFAHREN ZUR HERSTELLUNG EINER I-III-VI VERBINDUNG IN DÜNNSCHICHT FORM, DAS DIE EINBRINGUNG VON ELEMENTEN DER III GRUPPE IN DER DÜNNSCHICHT ERLEICHTERT
METHOD OF PRODUCING THIN FILMS OF COMPOUND I-III-VI, PROMOTING THE INCORPORATION OF III ELEMENTS IN THE FILM

(30) Priorité: 26.12.2002 FR 0216711
(43) Date de publication de la demande: 21.09.2005
(73) Titulaire: Electricité de France, Société Anonyme, 75008 Paris (FR); CENTRE NATIONAL DE LA RECHERCHE SCIENTIFIQUE -CNRS-, 75016 Paris (FR)
(72) Inventeur: TAUNIER, Stéphane, F-75012 Paris (FR); GUIMARD, Denis, F-75013 Paris (FR); LINCOT, Daniel, F-92160 Antony (FR); GUILLEMOLES, Jean-François, F-75013 Paris (FR); GRAND, Pierre-Philippe, F-92500 Rueil-Malmaison (FR)
(74) Mandataire: Cabinet Plasseraud
(86) Numéro de dépôt international: PCT/FR2003/003887
(87) Numéro de publication internationale: WO 2004/061924

(56) Documents cités:
- WO-A-02/077322
- US-A- 5 275 714
- US-A1- 2002 189 665
- OBREJA P ET AL: "Preparation and properties of electrodeposited InSe and CuxSe thin films" 6 octobre 1998 (1998-10-06) , SEMICONDUCTOR CONFERENCE, 1998. CAS '98 PROCEEDINGS. 1998 INTERNATIONAL SINAIA, ROMANIA 6-10 OCT. 1998, NEW YORK, NY, USA,IEEE, US, PAGE(S) 233-236 XP010313827 ISBN: 0-7803-4432-4 le document en entier
- DATABASE INSPEC [en ligne] THE INSTITUTION OF ELECTRICAL ENGINEERS, STEVENAGE, GB; FALL M ET AL: "Electrochemical and spectroscopic properties of poly(3-methoxythiophene) electrosynthesized in an aqueous micellar medium" XP002254320 & SYNTHETIC METALS, ELSEVIER, SWITZERLAND, vol. 93, no. 3, 31 mars 1998 (1998-03-31), pages 175-179, ISSN: 0379-6779
- OBREJA P ET AL: "CuInSe2 thin films for solar cells", IEEE,, vol. 2, 7 October 1997 (1997-10-07), pages 475-478, XP010266956, DOI: 10.1109/SMICND.1997.651259 ISBN: 978-0-7803-3804-3

## Description

La présente invention concerne la fabrication de semi-conducteurs de type I-III-VI₂ en couches minces, notamment pour la conception de cellules solaires.

Les composés I-III-VI₂ de type CuIn₍₁₋ₓ₎GaₓSe_{y}S_{(2-y)} (où x est sensiblement compris entre 0 et 1 et y est sensiblement compris entre 0 et 2) sont considérés comme très prometteurs et pourraient constituer la prochaine génération de cellules photovoltaïques en couche mince. Ces composés ont une largeur de bande interdite directe comprise entre 1,05 et 1,6 eV qui permet une forte absorption des radiations solaires dans le visible.

Les rendements records de conversion photovoltaïque ont été obtenus en préparant des couches minces par évaporation sur de petites surfaces. Cependant l'évaporation est difficile à adapter à l'échelle industrielle en raison de problèmes de non-uniformité et de faible utilisation des matières premières. La pulvérisation cathodique (méthode dite de *"sputtering"*) est mieux adaptée aux grandes surfaces mais elle nécessite des équipements sous vide et des cibles de précurseurs très coûteux.

Il existe donc un réel besoin pour des techniques alternatives à faible coût et à pression atmosphérique. La technique de dépôt de couche mince par électrochimie, en particulier par électrolyse, se présente comme une alternative très séduisante. Les avantages de cette technique de dépôt sont nombreux et notamment les suivants :
- dépôt à température et pression ambiantes dans un bain d'électrolyse,
- possibilité de traiter de grandes surfaces avec une bonne uniformité,
- facilité de mise en oeuvre,
- faible coût d'installation et des matières premières (pas de mise en forme particulière, taux d'utilisation élevé des matières), et
- grande variété des formes possibles de dépôt, due à la nature localisée du dépôt sur le substrat.

Malgré de nombreuses recherches dans cette voie, les difficultés rencontrées ont porté sur le contrôle de la qualité des précurseurs électrodéposés (composition et morphologie) et, plus particulièrement, sur la difficulté d'insérer des métaux tels que le gallium ou l'aluminium (éléments III) dont le potentiel d'électrodéposition est très cathodique.

Le document Obreja et al, "Cu In Se2 thin films for solarcells", International Semiconductor Conference CAS 1997, traite de l'électrolyse du Cu In Se₂ sans toutefois faire référence à une quelconque insertion de Gallium ou d'aluminium dans une telle couche.

On note ci-après les composés I-III-VI₂ où :
- l'élément I correspond à Cu,
- l'élément III correspond à In et à Ga et/ou Al, et
- l'élément VI correspond à Se et/ou S,
par l'abréviation "*CIGS*"*.*

Par ailleurs, on entend par le terme "*film*", une couche mince déposée sur substrat et par le terme *"film de précurseurs",* une couche mince de composition globale voisine de I-III-VI₂ et directement obtenue après le dépôt par électrolyse, sans traitement ultérieur éventuel.

En ce qui concerne l'électrodéposition pure de CIGS (sans étape d'évaporation), la morphologie et la composition des précurseurs est très difficile à contrôler, comme l'indique les documents :
- "One step electrodeposited CuIn1-xGaxSe2 thin films: structure and morphology", Fahourme M., Chraibi F., Aggour M., Delplancke J.L., Ennaoui A., and Lux-Steiner M, 17th European Photovoltaic Solar Energy Conference, 22-26 October 2001, Münich, Allemagne ; et
- *"*CuIn1-xGaxSe2-based photovoltaic cells from electrodeposited precursor films", Materials Research Society Symposium - Proceedings, Volume 668,2001, Pages H8101-H8106, Bhattacharya, R.N., Fernandez, Arturo M.

Les développements les plus récents font suivre l'électrodéposition d'une étape d'évaporation afin d'accroître les teneurs en In et Ga des films électrodéposés. Dans ces développements notamment décrits dans le document WO-01/78154, l'électrodéposition est une co-déposition réelle des éléments Cu, In, Ga et Se (pour l'obtention d'un alliage quaternaire) et elle met en oeuvre un procédé de dépôt dans un bain électrolytique tamponné en pH. La solution tampon est composée d'acide sulfamique et de biphtalate de potassium, formant un tampon de type pHydrion (marque déposée). Des films électrodéposés ayant donné des cellules photovoltaïques par le procédé hybride mettant en oeuvre un électrodépôt suivi d'une étape d'évaporation, ont une morphologie dendritique et peu compacte.

La présente invention vient améliorer la situation.

Elle propose à cet effet un procédé de fabrication selon la revendication 1. Le document de l'art antérieur: "Preparation and properties of electrodeposited InSe and CuxSe thin films" P. Obreja et al., International semiconductor Conference CAS 6/10/1998, décrit l'ajout d'un tensioactif dans un bain d'électrolyse, mais pour la fabrication de binaires InSe et CuSe. Au sens de l'invention, on cherche à fabriquer directement un alliage ternaire I-III-VI et les mécanismes en jeu sont radicalement différents.

Avantageusement, l'élément III comporte du gallium et/ou de l'aluminium.

Préférentiellement, le composé tensioactif comporte une formule chimique du type CH₃(CH₂)ₙO-SO₃-X, où n est supérieur ou égal à 5 et X est une espèce atomique telle que H, Na, Li ou K.

Dans un mode de réalisation préféré, le composé tensioactif comporte du dodécylsulfate de sodium.

En variante ou en complément, le composé tensioactif comporte du 2-Butyne-1,4-diol et/ou de l'acide maléique et/ou de l'acide succinique et/ou de l'acide fumarique et/ou de l'acide crotonique.

La concentration de tensioactif dans le bain d'électrolyse est sensiblement d'un même ordre de grandeur que la concentration en gallium et/ou en aluminium.

D'autres avantages et caractéristiques de l'invention apparaîtront à la lecture de la description détaillée ci-après de modes de réalisation donnés à titre d'exemples non limitatifs, ainsi qu'à l'examen des dessins qui l'accompagnent et sur lesquels :
- la figure 1 représente schématiquement une couche mince obtenue par la mise en oeuvre du procédé selon l'invention,
- la figure 2 représente schématiquement un bain d'électrolyse pour la mise en oeuvre du procédé selon l'invention,
- la figure 3 représente schématiquement l'aspect d'une couche mince de l'art antérieur, vue de dessus,
- et la figure 4 représente schématiquement une vue en coupe d'une couche mince de l'art antérieur, en formation.

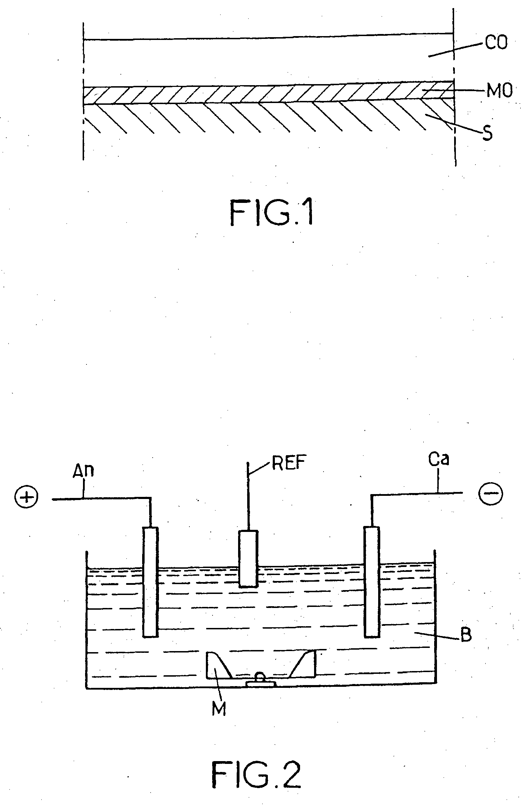

En se référant à la figure 1, des couches CO de diséléniure de cuivre et d'indium-gallium (en tant qu'élément III) sont obtenues à pression et température ambiantes par électrodéposition d'une couche mince de précurseurs de composition et de morphologie adaptée, sur un substrat de verre S recouvert de molybdène MO. L'électrodéposition est effectuée à partir d'un bain acide B (figure 2), agité par des pales M, contenant un sel d'indium, un sel de gallium, un sel de cuivre et de l'oxyde de sélénium dissous. Les concentrations de ces éléments précurseurs sont comprises entre 10⁻⁴ et 10⁻² M, où la notation "M" correspond à l'unité *"mole par litre".* Le pH de la solution est fixé entre 1 et 4.

Trois électrodes An, Ca et REF, dont :
- une électrode de molybdène Ca sur laquelle se forme la couche mince par électrodéposition,
- et une électrode de référence au sulfate mercureux REF, sont immergées dans le bain B.

La différence de potentiel électrique appliquée à l'électrode de molybdène est comprise entre -0,8 et -1,4 V par rapport à l'électrode de référence REF.

Des couches d'épaisseur comprise entre 1 et 4 microns sont obtenues, avec des densités de courant comprises entre 0,5 et 10 mA/cm².

Dans des conditions définies de composition, d'agitation de la solution et de différence de potentiel, il est possible d'obtenir des couches denses, adhérentes, de morphologie homogène et dont la composition est proche de la composition stoechiométrique : Cu (25%), In+Ga (25+ε%) et Se (50%), avec un ratio atomique (In+Ga)/Cu légèrement supérieur à 1. On peut ainsi réaliser des dépôts sur des surfaces de 10x10 cm².

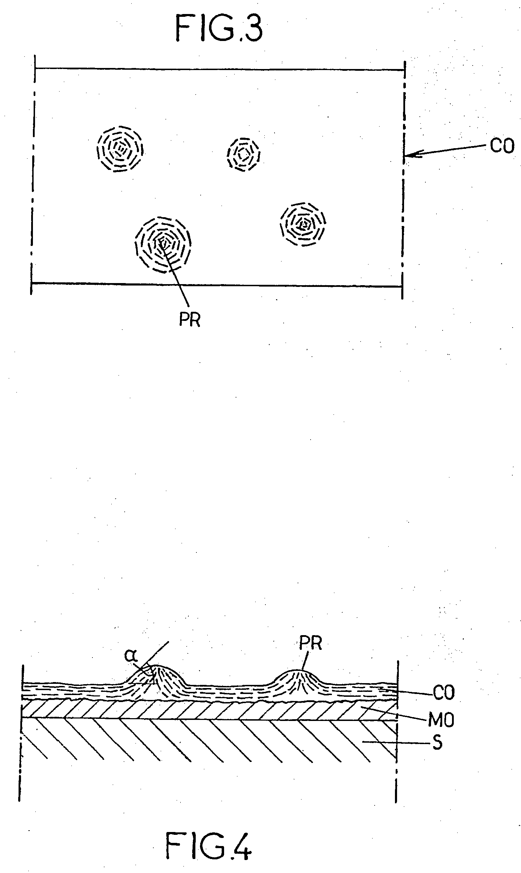

Néanmoins, l'incorporation de gallium pour former les couches minces de CIGS pose souvent un problème, tant sur le plan de leur morphologie que de leur composition. En se référant à la figure 3, les couches de précurseurs CO, en formation par électrolyse dans des conditions classiques, présentent à la surface des protubérances PR formant un angle α non nul par rapport au plan principal de la surface de la couche (figure 4) . Une telle morphologie de la couche mince, particulièrement rugueuse en sa surface, n'est pas compatible avec la fabrication de cellules photovoltaïques, lesquelles nécessitent des interfaces les plus parallèles et planes possibles pour limiter la déperdition de lumière et surtout éviter des courts-circuits locaux (ou "*shunts*").

En outre, la composition en volume de ces dépôts est pauvre en gallium (généralement inférieure à 5%) et inférieure, en tout état de cause, à celle initialement souhaitée.

L'approche proposée dans le document WO-01/78154 consiste à contrôler l'acidité du bain d'électrolyse pour assurer la stabilité de son pH et, de là, favoriser une incorporation du gallium (élément dont le potentiel de dépôt est très négatif) dans les couches de CIGS en formation. A cet effet, il est prévu dans ce document une solution tampon comprenant de l'acide sulfamique et du biphtalate de potassium en concentrations suffisantes pour assurer la stabilité du pH. Des couches de CuIn₍₁₋ₓ₎GaₓSe₂ sont alors obtenues avec x voisin de 9%.

Dans une autre approche, la présente invention propose d'ajouter un ou plusieurs additifs tensioactifs dans le bain d'électrolyse pour former les couches de CIGS. Des couches de CuIn₍₁₋ₓ₎GaₓSe₂ obtenues par la mise en oeuvre du procédé selon l'invention présentent une morphologie satisfaisante, ainsi qu'un pourcentage x de gallium voisin, voire supérieur, à la valeur de 9% précitée, comme on le verra plus loin en référence à un mode de réalisation préféré.

Une explication possible de cette amélioration de la qualité des couches par ajout de tensioactifs dans le bain est la suivante. L'ajout d'un composé tensioactif, agissant dans le bain en s'adsorbant à l'électrode Ca sur laquelle se forme la couche mince, permet de modifier la tension de surface à l'interface entre la couche mince en formation et la solution du bain. On abaisse ainsi l'énergie d'activation de la réaction d'incorporation du gallium combiné au sélénium dans la couche mince. Le mélange du gallium aux autres éléments Cu, In et Se permet alors d'obtenir une morphologie homogène de la couche, ainsi qu'une composition riche en gallium.

Une autre explication possible, complémentaire de la précédente, est que les tensioactifs utilisés peuvent en outre avoir un rôle inhibiteur de la réaction de dégagement d'hydrogène observée habituellement en électrolyse, ce qui permettrait l'application de potentiels plus cathodiques, favorisant ainsi l'incorporation de gallium.

On note en outre un effet niveleur des tensioactifs ajoutés, permettant d'aplanir la surface de la couche en formation.

Ainsi, selon l'invention, un ou plusieurs additifs tensioactifs permettant d'améliorer la morphologie et/ou de changer les ratios relatifs des divers éléments électrodéposés (Cu-In-Ga-Se) sont ajoutés dans la solution. On retiendra que leur rôle principal est d'aider à l'insertion du gallium dans les couches de précurseurs. La quantité de gallium pouvant être insérée dans les films peut varier de 0 à 30 % (en pourcentage atomique). La concentration des additifs peut varier de 10⁻⁵ à 10⁻² M.

On donne ci-après différents modes de réalisation de l'invention, avec comme additifs tensioactifs :
- le dodécylsulfate de sodium;
- le 2-Butyne-1,4-diol;
- l'acide succinique;
- l'acide fumarique;
- l'acide maléique.

### Mode de réalisation préféré: "dodécylsulfate de sodium"

Un dépôt typique est réalisé à partir d'un bain acide dont les concentrations en éléments précurseurs et en tensioactif CH₃(CH₂)₁₁OSO₃Na sont les suivantes :

[CuSO₄] =4, 5.10⁻³ M,

[In₂(SO₄)₃] =2, 5.10⁻³ M,

[Ga₂(SO₄)₃] =2, 5.10⁻³ M,

[H₂SeO₃] = 7,5.10⁻³ M,

[CH₃(CH₂)₁₁OSO₃Na]=20.10⁻³ M.

Les précurseurs sont déposés par une réaction cathodique à potentiel imposé, à -1,1 V par rapport à l'électrode REF. La densité de courant est de -5 mA/cm².

**Tableau I : Analyse de la composition d'un film de CIGS électrodéposé dans une solution contenant du dodécylsulfate de sodium.**

| Elément | %Atomique |
|---|---|
| Cu | 20.70 |
| **Ga** | **10.27** |
| Se | 50.94 |
| In | 18.10 |

Avantageusement, la morphologie de la couche est très homogène.

De façon plus générale, on indique que l'ajout de tensioactifs de formule CH₃(CH₂)ₙO-SO₃-X (où n est supérieur ou égal à 5 et X est une espèce atomique telle que H, Na, Li ou K) donne des résultats satisfaisants.

### Second mode de réalisation : "2-Butyne-1,4-diol"

Un dépôt typique est réalisé à partir d'un bain acide dont les concentrations en éléments précurseurs et en tensioactif HO-CH₂-C≡C-CH₂-OH sont les suivantes :

[CuSO₄] =4, 5.10⁻³ M,

[In₂(SO₄)₃] =2, 5.10⁻³ M,

[Ga₂(SO₄)₃] =2,5.10⁻³ M,

[H₂SeO₃] = 7,5.10⁻³ M,

**[HO-CH₂-C≡C-CH₂-OH] =20.10⁻³ M.**

Les précurseurs sont déposés par une réaction cathodique à potentiel imposé, à -1,1 V par rapport à l'électrode REF. La densité de courant est de -5 mA/cm².

**Tableau II : Analyse de la composition d'un film de CIGS électrodéposé dans une solution contenant du 2-Butyne-1,4-diol.**

| Elément | %Atomique |
|---|---|
| Cu | 23.10 |
| **Ga** | **1.80** |
| Se | 53.50 |
| In | 21.54 |

La morphologie de la couche est peu homogène. Toutefois, aucun décollement de la couche n'a été observé.

### Troisième mode de réalisation: "acide maléique"

Un dépôt typique est réalisé à partir d'un bain acide dont les concentrations en éléments précurseurs et en tensioactif HO₂C-CH=CH-CO₂H sont les suivantes :

[CuSO₄] =4, 5.10⁻³ M,

[In₂(SO₄)₃] =2, 5.10⁻³ M,

[Ga₂(SO₄)₃]=2, 5.10⁻³ M,

[H₂SeO₃] =7, 5.10⁻³ M,

**[HO₂C-CH=CH-CO₂H] =20.10⁻³ M.**

Les précurseurs sont déposés par une réaction cathodique à potentiel imposé, à -1,1 V par rapport à l'électrode REF. La densité de courant est de -5 mA/cm².

**Tableau III : Analyse de la composition d'un film de CIGS électrodéposé dans une solution contenant de l'acide maléique.**

| Elément | %Atomique |
|---|---|
| Cu | 23.32 |
| Ga | **3.10** |
| Se | 53.32 |
| In | 20.26 |

La morphologie de la couche est sensiblement homogène.

### Quatrième mode de réalisation : "acide succinique"

Un dépôt typique est réalisé à partir d'un bain acide dont les concentrations en éléments précurseurs et en tensioactif HO₂-CH₂-CH₂-CO₂H sont les suivantes :

[CuSO₄] =4,5.10⁻³ M,

[In₂(SO₄)₃] =2,5.10⁻³ M,

[Ga₂(SO₄)₃] =2,5.10⁻³ M,

[H₂SeO₃] =7,5.10⁻³ M,

[HO₂-CH₂-CH₂-CO₂H]=20.10⁻³ M.

Les précurseurs sont déposés par une réaction cathodique à potentiel imposé, à -1,1 V par rapport à l'électrode REF. La densité de courant est de -5 mA/cm².

**Tableau IV : Analyse de la composition d'un film de CIGS électrodéposé dans une solution contenant de l'acide succinique.**

| Elément | %Atomique |
|---|---|
| Cu | 23.69 |
| **Ga** | **3.99** |
| Se | 52.33 |
| In | 19.99 |

La morphologie de la couche est avantageusement homogène.

### Cinquième mode de réalisation: "acide fumarique"

Un dépôt typique est réalisé à partir d'un bain acide dont les concentrations en éléments précurseurs et en tensioactif HO₂-CH-CH-CO₂H sont les suivantes :

[CuSO₄] =4,5.10⁻³ M,

[In₂(SO₄)₃] =2,5.10⁻³ M,

[Ga₂(SO₄)₃] =2,5.10⁻³ M,

[H₂SeO₃] =7,5.10⁻³ M,

**[HO₂-CH-CH-CO₂H] = 20.10⁻³ M.**

Les précurseurs sont déposés par une réaction cathodique à potentiel imposé, à -1,1 V par rapport à l'électrode REF. La densité de courant est de -5 mA/cm².

**Tableau V : Analyse de la composition d'un film de CIGS électrodéposé dans une solution contenant de l'acide fumarique.**

| Elément | %Atomique |
|---|---|
| Cu | 24.54 |
| **Ga** | **2.85** |
| Se | 52.60 |
| In | 20.00 |

La morphologie de la couche est sensiblement homogène.

De manière plus générale, l'additif au sens de l'invention peut être un composé tensioactif parmi les deux classes suivantes :
- les composés tensioactifs dont la molécule contient le groupement X-SO₃-Y ou Z-SO₂-Z', où :
   ∘ Y est un élément parmi H, Na, Li, K ;
   ∘ X est un groupe insaturé (éthylénique, aromatique, acétylénique) pouvant comporter des hétéro-atomes, avec un nombre d'atomes de carbone quelconque, ou encore un groupe saturé pouvant comporter des hétéro-atomes ;
   ∘ Z et Z' sont des groupements saturés ou insaturés pouvant comporter des hétéro-atomes (S, N, ou autres),
- et les composés dont la molécule possède au moins un groupe polaire : -OH- COOH, -S (ou autre hétéroatome) et/ou un groupement insaturé : alcène, alcyne, aromatique (avec ou sans hétéro-atome), permettant l'adsorption de la molécule au cours de l'électrodépôt.

Chaque composé de l'une des deux familles peut être utilisé seul ou en mélange. Un même composé peut appartenir aux deux familles (s'il possède au moins un groupement insaturé et au moins un groupement de SO₂).

On indique que ces composés tensioactifs se distinguent des solvants organiques habituels dont le rôle de solvatation agit seulement sur la solution du bain. Ils se distinguent aussi des additifs organiques introduits dans le bain d'électrolyse pour en stabiliser le pH.

Les composés tensioactifs décrits ci-avant peuvent être aisément utilisés pour tout type de bain d'électrolyse permettant l'électrodéposition de systèmes I-III-VI tels que Cu-In-Ga-Al-Se-S.

Les agents tensioactifs permettant d'insérer du gallium dans les couches de précurseurs permettent ainsi de résoudre plusieurs difficultés décrites dans l'état de l'art (mauvais contrôle de la morphologie, de la composition des précurseurs, en particulier pour ce qui concerne le taux de gallium, difficultés d'extension aux grandes surfaces).

Bien entendu, la présente invention ne se limite pas à la forme de réalisation décrite ci-avant à titre d'exemple ; elle s'étend à d'autres variantes.

Ainsi, on comprendra que l'aluminium, en tant qu'élément III, pose sensiblement les mêmes problèmes d'incorporation dans les couches de Cu-In-Al-Se que le gallium. A ce titre, l'invention peut s'appliquer en outre à la fabrication des telles couches. Par ailleurs, on introduit habituellement de l'indium en excès dans la solution du bain pour favoriser son incorporation dans la couche, l'indium se combinant, en tant qu'élément III, au sélénium. On indique que l'ajout de tensioactifs dans le bain devrait aussi favoriser l'incorporation de l'indium, en tant qu'élément III, dans la couche.

Par ailleurs, on indique en outre que l'acide crotonique, en tant qu'additif tensioactif, a aussi fourni des résultats satisfaisants.

## Revendications

1. Procédé de fabrication par électrochimie d'un composé I-III-VI_{y} en couches minces, où y est voisin de 2,
dans lequel :
- l'élément I correspond au cuivre,
- l'élément VI correspond au soufre et/ou au sélénium
- et l'élément III correspond à l'indium, avec du gallium et/ou de l'aluminium,
le procédé comportant les étapes suivantes :
- on prévoit un bain d'électrolyse comportant les éléments I, III, VI, précités, dissous dans le bain et au moins deux électrodes immergées dans le bain,
- on applique une différence de potentiel entre les deux électrodes pour amorcer la formation d'une couche mince de I-III-VI_{y} sur la surface de l'une des électrodes,
**caractérisé en ce que** le bain d'électrolyse comporte en outre au moins un composé tensioactif, en concentration d'un même ordre de grandeur que la concentration en gallium et/ou en aluminium dans le bain, pour favoriser l'incorporation du gallium et/ou de l'aluminium dans ladite couche.

2. Procédé selon la revendication 1, **caractérisé en ce que** le composé tensioactif comporte une formule chimique CH₃(CH₂)ₙO-SO₃-X, où n est supérieur ou égal à 5 et X est une espèce atomique telle que H, Na, Li ou K.

3. Procédé selon la revendication 2, **caractérisé en ce que** le composé tensioactif comporte du dodécylsulfate de sodium.

4. Procédé selon la revendication 1, **caractérisé en ce que** le composé tensioactif comporte du 2-Butyne-1,4-diol.

5. Procédé selon la revendication 1, **caractérisé en ce que** le composé tensioactif comporte de l'acide maléique.

6. Procédé selon la revendication 1, **caractérisé en ce que** le composé tensioactif comporte de l'acide succinique.

7. Procédé selon la revendication 1, **caractérisé en ce que** le composé tensioactif comporte de l'acide fumarique.

8. Procédé selon la revendication 1, **caractérisé en ce que** le composé tensioactif comporte de l'acide crotonique.

## Patentansprüche

1. Verfahren zur elektrochemischen Herstellung einer I-III-VI_{y}-Verbindung in Dünnschichtform, wobei y in der Nähe von 2 liegt, bei dem:
- das Element I Kupfer entspricht,
- das Element VI Schwefel und/oder Selen entspricht
- und das Element III Indium mit Gallium und/oder Aluminium entspricht,
wobei das Verfahren die folgenden Schritte umfasst:
- man stellt ein Elektrolysebad, das die oben genannten Elemente I, III und VI in dem Bad gelöst enthält, und mindestens zwei in das Bad eingetauchte Elektroden bereit,
- man legt zwischen den beiden Elektroden eine Potenzialdifferenz an, um die Bildung einer I-III-VI_{y}-Dünnschicht auf der Oberfläche einer der Elektroden zu initiieren,
**dadurch gekennzeichnet, dass** das Elektrolysebad außerdem mindestens eine oberflächenaktive Verbindung in einer Konzentration in der gleichen Größenordnung wie die Konzentration an Gallium und/oder Aluminium in dem Bad umfasst, um den Einbau des Galliums und/oder Aluminiums in die Schicht zu fördern.

2. Verfahren nach Anspruch 1, **dadurch gekennzeichnet, dass** die oberflächenaktive Verbindung die chemische Formel CH₃(CH₂)ₙO-SO₃-X aufweist, wobei n größer gleich 5 ist und X für eine Atomspezies wie H, Na, Li oder K steht.

3. Verfahren nach Anspruch 2, **dadurch gekennzeichnet, dass** die oberflächenaktive Verbindung Natriumdodecylsulfat umfasst.

4. Verfahren nach Anspruch 1, **dadurch gekennzeichnet, dass** die oberflächenaktive Verbindung 2-Butin-1,4-diol umfasst.

5. Verfahren nach Anspruch 1, **dadurch gekennzeichnet, dass** die oberflächenaktive Verbindung Maleinsäure umfasst.

6. Verfahren nach Anspruch 1, **dadurch gekennzeichnet, dass** die oberflächenaktive Verbindung Bernsteinsäure umfasst.

7. Verfahren nach Anspruch 1, **dadurch gekennzeichnet, dass** die oberflächenaktive Verbindung Fumarsäure umfasst.

8. Verfahren nach Anspruch 1, **dadurch gekennzeichnet, dass** die oberflächenaktive Verbindung Crotonsäure umfasst.

## Claims

1. A method of producing a I-III-VI_{y} compound in thin film form, in which y is close to 2, by electrochemistry, wherein:
- element I is copper,
- element VI is sulfur and/or selenium,
- and element III comprises indium, with gallium and/or aluminum,
the method comprising the following steps:
- an electrolysis bath comprising said elements I, III, and VI dissolved in the bath, and at least two electrodes immersed in the bath are provided;
- a potential difference is applied between the two electrodes in order to initiate the formation of a thin film of I-III-VI_{y} on the surface of one of the electrodes,
**characterized in that** the electrolysis bath furthermore includes at least one surfactant compound with a concentration of the surfactant in the electrolysis bath which is substantially of the same order of magnitude as the concentration of gallium and/or aluminum in the bath, in order to promote the incorporation of gallium and/or aluminum into said film.

2. The method as claimed in claim 1, **characterized in that** the surfactant compound has a chemical formula CH₃(CH₂)ₙO-SO₃-X, where n is greater than or equal to 5 and X is an atomic species such as H, Na, Li or K.

3. The method as claimed in claim 2, **characterized in that** the surfactant compound comprises sodium dodecylsulfate.

4. The method as claimed in claim 1, **characterized in that** the surfactant compound comprises 2-butyne-1,4-diol.

5. The method as claimed in claim 1, **characterized in that** the surfactant compound comprises maleic acid.

6. The method as claimed in claim 1, **characterized in that** the surfactant compound comprises succinic acid.

7. The method as claimed in claim 1, **characterized in that** the surfactant compound comprises fumaric acid.

8. The method as claimed in claim 1, **characterized in that** the surfactant compound comprises crotonic acid.
